# EUROPÄISCHE PATENTSCHRIFT

(11) **EP 2 429 078 B1**
(45) Veröffentlichungstag und Bekanntmachung des Hinweises auf die Patenterteilung: **21.11.2018**
(21) Anmeldenummer: 11178810.5
(22) Anmeldetag: 25.08.2011
(51) Int. Cl.: H03K 17/96, H03K 17/955

(54) **Kapazitive Bedieneinrichtung für ein Haushaltsgerät, Haushaltsgerät und Verfahren zum Betreiben einer kapazitiven Bedieneinrichtung in einem Haushaltsgerät**
Capacitative operating device for a domestic appliance, domestic appliance and method for operating a capacitative operating device in a domestic appliance
Dispositif de commande capacitif pour un appareil ménager, appareil ménager et procédé de fonctionnement d'un dispositif de commande capacitif dans un appareil ménager

(30) Priorität: 08.09.2010 DE 102010040434
(43) Veröffentlichungstag der Anmeldung: 14.03.2012
(73) Patentinhaber: BSH Hausgeräte GmbH, 81739 München (DE)
(72) Erfinder: Hajduk, Lubos, 07211 Michalovce (SK); Mondok, Marek, 07101 Michalovce (SK); Piermeier, Simon, 94379 Sankt Englmar (DE)

(56) Entgegenhaltungen:
- EP-A1- 2 315 337
- EP-A2- 2 037 582
- DE-A1-102005 041 113
- US-A- 4 954 823
- US-A1- 2008 088 323

## Beschreibung

Die Erfindung betrifft eine kapazitive Bedieneinrichtung für ein Haushaltsgerät. Die Bedieneinrichtung umfasst einen kapazitiven Sensor mit einer elektrischen Kapazität, die aufgrund einer Betätigung des Sensors durch eine Bedienperson und/oder einer Annäherung der Bedienperson an den Sensor veränderbar ist. Die Bedieneinrichtung umfasst auch eine mit dem Sensor gekoppelte Aufbereitungsschaltung, welche zum Empfangen eines Eingangssignals und zum Ausgeben eines von der Kapazität des Sensors abhängigen Ausgangssignals aufgrund des Eingangssignals ausgebildet ist. Eine mit der Aufbereitungsschaltung gekoppelte Steuereinrichtung stellt das Eingangssignal für die Aufbereitungsschaltung bereit und erkennt die Betätigung des Sensors und/oder die Annäherung an den Sensor in Abhängigkeit von dem Ausgangssignal der Aufbereitungsschaltung. Die Erfindung bezieht sich außerdem auf ein Haushaltsgerät mit einer solchen kapazitiven Bedieneinrichtung, wie auch auf ein Verfahren zum Bertreiben einer kapazitiven Bedieneinrichtung in einem Haushaltsgerät.

Kapazitive Bedieneinrichtungen für Haushaltsgeräte sind bereits aus dem Stand der Technik in vielfältiger Ausgestaltung bekannt. Eine bekannte Bedieneinrichtung für ein Haushaltsgerät ist bereits in der Druckschrift DE 10 2005 041 113 A1 beschrieben: Die Bedieneinrichtung erfasst einen kapazitiven Sensor, dessen Kapazität sich bei einer Betätigung durch eine Bedienperson verändert. Der Sensor ist mit einem Steueranschluss eines PNP-Bipolartransistors gekoppelt, nämlich über einen Ohmschen Widerstand. Der PNP-Bipolartransistor ist ein Teil einer Aufbereitungsschaltung, welche an ihrem Eingang ein Eingangssignal von einem Mikrocontroller empfängt und an ihrem Ausgang ein Ausgangssignal ausgibt, anhand dessen der Mikrocontroller erkennen kann, ob die Bedienperson den Sensor betätigt oder nicht. Das Eingangssignal umfasst eine Vielzahl von Spannungsimpulsen, mit denen der Emitter des Bipolartransistors beaufschlagt wird. Am Kollektor des Bipolartransistors werden somit Spannungsimpulse ausgegeben, deren Höhe abhängig von der Kapazität des Sensors ist. Diese Spannungsimpulse werden durch ein Abtast-Halte-Glied mit zwei Bipolartransistoren abgegriffen und in eine Gleichspannung gewandelt, deren Amplitude abhängig von der Höhe der Spannungsimpulsen und somit abhängig von der Kapazität des Sensors ist. Betätigt die Bedienperson - die das elektrische Potential der Erde führt - den Sensor, so erhöht sich die Amplitude der Gleichspannung am Ausgang des Abtast-Halte-Gliedes. Diese Amplitude wird durch den Mikrokontroller dahingehend ausgewertet, ob eine Betätigung des Sensors vorliegt oder nicht.

Es ist außerdem Stand der Technik, auf das Abtast-Halte-Glied zu verzichten. Stattdessen kann ein Ausgangskondensator eingesetzt werden, nämlich auf der Seite des Kollektors des PNP-Bipolartransistors. Ein solcher Ausgangskondensator kann also zwischen dem Kollektor und dem Bezugspotential (Masse) geschaltet sein. Das am Kollektor ausgegebene Ausgangssignal beinhaltet dann Spannungsimpulse, deren Höhe in Abhängigkeit von der Kapazität des Sensors variiert. Diese Spannungsimpulse werden vom Mikrocontroller abgegriffen, und der Mikrocontroller kann anhand der Höhe der Spannungsimpulse erkennen, ob die Bedienperson den Sensor betätigt bzw. sich dem Sensor annähert oder nicht.

Betätigt die Bedienperson den Sensor, so erhöht sich die maximale Amplitude der Spannungsimpulse, die durch die Aufbereitungsschaltung ausgegeben werden. Im Prinzip kann festgestellt werden, dass die Kapazität des kapazitiven Sensors insgesamt aus zwei Anteilen besteht: einem statischen Anteil und einem dynamischen Anteil. Der statische Anteil ist alleine von den Eigenschaften der Umgebung und der verwendeten Komponenten abhängig, nämlich von der Temperatur, der Feuchtigkeit der Umgebung, wie auch von dem verwendeten Material für den Schaltungsträger (PCB), nämlich von parasitären Kapazitäten des Schaltungsträgers. Dieser statische Anteil der Kapazität ist somit prinzipiell konstant und kann sich lediglich ein wenig verändern, nämlich abhängig von den genannten Parametern. Hingegen geht es bei dem dynamischen Anteil um denjenigen, welcher alleine auf die Betätigung durch die Bedienperson bzw. auf die Annäherung zurückzuführen ist. Der dynamische Anteil verändert sich somit abhängig davon, ob die Bedienperson den Sensor betätigt bzw. sich dem Sensor annähert oder nicht. Entsprechend besitzt das von der Aufbereitungsschaltung ausgegebene Ausgangssignal ebenfalls einen statischen Amplitudenanteil, wie auch einen dynamischen Amplitudenanteil. Der statische Amplitudenanteil der ausgegebenen Spannungsimpulse hängt von dem statischen Anteil der Kapazität des Sensors ab und ist somit mit dem statischen Anteil der Kapazität korreliert. Demgegenüber hängt der dynamische Amplitudenanteil des Ausgangssignals mit dem dynamischen Anteil der Kapazität zusammen und ist somit mit diesem korreliert. Der statische Anteil der Kapazität und somit der statische Amplitudenanteil des Ausgangssignals sind relativ groß. Wenn es darum geht, eine Berührung des Sensors durch eine Bedienperson zu erkennen, so ist diese Aufgabe relativ einfach: Der dynamische Anteil der Kapazität und somit der dynamische Amplitudenanteil sind in diesem Fall groß genug, um eine ausreichende Veränderung der gesamten Kapazität und der Amplitude des Ausgangssignals zu verursachen. Diese Veränderung reicht für die Erkennung der Berührung aus. Ganz anders stellt sich diese Situation jedoch dann dar, wenn sich die Bedienperson dem Sensor lediglich annähert und diese Annäherung durch den Mikrocontroller erkannt werden soll - z. B. bei einem Annäherungssensor. Dann ist der dynamische Anteil der Kapazität sehr gering gegenüber dem statischen, so dass entsprechend auch eine sehr geringe Änderung der Amplitude des Ausgangssignals gegeben ist. Diese Änderung ist manchmal so gering, dass der Mikrocontroller überhaupt nicht in der Lage ist, die Annäherung zu erkennen. Die Empfindlichkeit einer solchen Bedieneinrichtung findet somit ihre Grenzen bei der Erkennung einer Annäherung.

Es ist auch eine Herausforderung, das Ausgangssignal der Aufbereitungsschaltung bei einem so genannten zweidimensionalen kapazitiven Sensor auszuwerten. Ein solcher Sensor weist in der Regel eine Sensorfläche auf, und der Mikrocontroller soll anhand des Ausgangssignals der Aufbereitungsschaltung erkennen, an welcher Stelle die Sensorfläche durch die Bedienperson betätigt wird. Die Sensorfläche ist in mehrere Spalten und Reihen unterteilt, die jeweils voneinander elektrisch getrennt sind. Es wird bei einer solchen Sensorfläche ein Multiplexer eingesetzt, welcher die einzelnen Reihen und Spalten abwechselnd und zyklisch mit der Aufbereitungsschaltung elektrisch verbindet. Wie die Erkennung einer Annäherung, ist auch die Erkennung der Stelle, an welcher die Bedienperson die Sensorfläche berührt, nicht ohne weiteres möglich. Hier ist zwar aufgrund der Berührung die Veränderung des dynamischen Anteils der Kapazität groß genug, jedoch verändert sich auch der statische Anteil der Kapazität.

Eine Schaltungsanordnung für einen kapazitiven Berührungsschalter ist auch aus dem Dokument EP 1 675 265 B1 bekannt.

Eine Bedieneinrichtung gemäß dem Oberbegriff des Patentanspruchs 1 ist beispielsweise aus dem Dokument US 2008/0088323 A1 bekannt. Von einem Sensorsignal wird mittels eines Verstärkers ein vorbestimmter Amplitudenanteil abgezogen und somit ein verstärktes Subtraktionssignal bereitgestellt. Dieses Subtraktionssignal wird einem Mikrocontroller zugeführt, welcher anhand des Subtraktionssignals die Betätigung eines kapazitiven Sensors erkennen kann.

Es ist Aufgabe der Erfindung, einen Weg aufzuzeigen, wie die Empfindlichkeit einer kapazitiven Bedieneinrichtung der eingangs genannten Gattung im Vergleich zum Stand der Technik erhöht werden kann.

Diese Aufgabe wird erwartungsgemäß durch eine kapazitive Bedieneinrichtung mit den Merkmalen gemäß Patentanspruch 1, durch ein Haushaltsgerät mit den Merkmalen des Patentanspruchs 10, wie auch durch ein Verfahren gelöst, welches die Merkmale des Patentanspruchs 11 aufweist. Vorteilhafte Ausführungen der Erfindung sind Gegenstand der abhängigen Patentansprüche und der Beschreibung.

Eine erfindungsgemäße kapazitive Bedieneinrichtung für ein Haushaltsgerät umfasst einen kapazitiven Sensor mit einer elektrischen Kapazität, welche aufgrund einer Betätigung des Sensors durch eine Bedienperson und/oder einer Annäherung der Bedienperson an den Sensor veränderbar ist. Sie umfasst auch eine mit dem Sensor gekoppelte Aufbereitungsschaltung, welche ein Eingangssignal empfängt und ein Ausgangssignal aufgrund des Eingangssignals ausgibt. Das Ausgangssignal ist von der Kapazität des Sensors abhängig. Mit der Aufbereitungsschaltung ist eine Steuereinrichtung gekoppelt, die das Eingangssignal für die Aufbereitungsschaltung bereitstellt und in Abhängigkeit von dem Ausgangssignal der Aufbereitungsschaltung erkennt, ob die Betätigung und/oder die Annäherung vorliegt oder nicht. Es sind Subtraktionsmittel bereitgestellt, welche einen Amplitudenanteil von einer Amplitude des Ausgangssignals der Aufbereitungsschaltung abziehen und ein Subtraktionssignal als Ergebnis der Subtraktion ausgeben. Die Steuereinrichtung ist dazu ausgelegt, anhand des Subtraktionssignals die Betätigung des Sensors und/oder die Annäherung an den Sensor zu erkennen.

Prinzipiell kann die Aufbereitungsschaltung gleich wie die Schaltung gemäß Druckschrift DE 10 2005 041 113 A1 aufgebaut sein. Der Energieverbrauch der Bedieneinrichtung kann jedoch auf ein Minimum reduziert werden, wenn die Aufbereitungsschaltung ein Eingangssignal mit einer Mehrzahl von Impulsen - insbesondere Spannungsimpulsen - empfängt und aufgrund des Eingangssignals ein Ausgangssignal mit einer entsprechenden Mehrzahl von Impulsen ausgibt, nämlich insbesondere mit einer entsprechenden Mehrzahl von Spannungsimpulsen.

Als Eingangssignal für die Aufbereitungsschaltung wird ein solches Signal bereitgestellt, welches eine Mehrzahl von Spannungsimpulsen aufweist. Die Steuereinrichtung stellt für die Aufbereitungsschaltung ein solches Eingangssignal bereit, welches in vorbestimmten Zeitabständen jeweils eine vorbestimmte Anzahl von Impulsen umfasst.

Demnach wird von der Amplitude des Ausgangssignals - welche sowohl den statischen als auch den dynamischen Amplitudenanteil beinhaltet - ein Amplitudenanteil abgezogen, so dass ein Subtraktionssignal bereitgestellt wird, dessen Amplitude einer Differenz zwischen der ursprünglichen Amplitude des Ausgangssignals und dem abgezogenen Anteil entspricht. Die Steuereinrichtung kann nun anhand des Subtraktionssignals erkennen, ob eine Betätigung des Sensors und/oder eine Annäherung an den Sensor vorliegt oder nicht. Die Erfindung hat den Vorteil, dass somit die Empfindlichkeit der kapazitiven Bedieneinrichtung im Vergleich zum Stand der Technik erhöht wird. Es wird nämlich von dem Ausgangssignal ein Amplitudenanteil abgezogen, so dass der statische Amplitudenanteil des Ausgangssignals reduziert wird. Das Subtraktionssignal besitzt somit ein besseres Verhältnis des dynamischen Amplitudenanteils zum statischen Amplitudenanteil. Die Betätigung bzw. Annäherung verursacht nun eine größere Veränderung der Amplitude des Subtraktionssignals. Auf diesem Wege gelingt es, die Auflösung bei der Auswertung des Ausgangssignals gegenüber dem Stand der Technik zu verbessern, ohne dass im Sättigungsbereich gearbeitet werden muss. Die Steuereinrichtung kann nun ohne viel Aufwand nicht nur eine Berührung bzw. Betätigung des Sensors erkennen, sondern auch eine Annäherung an den Sensor, wie auch gegebenenfalls eine Stelle, an welcher eine zweidimensionale Sensorfläche berührt wird.

Die Erfindung hat außerdem den Vorteil, dass aufgrund der erhöhten Empfindlichkeit keine Abschirmung des kapazitiven Sensors gegenüber dem elektrischen Erdepotential erforderlich ist; die Bedieneinrichtung kommt somit ohne eine zusätzliche Abschirmung aus, wie sie im Stand der Technik aufgrund der geringen Empfindlichkeit eingesetzt werden musste.

Unter einem Haushaltsgerät wird vorliegend ein Gerät verstanden, das zur Haushaltsführung eingesetzt wird. Das kann ein Haushaltsgroßgerät sein, wie beispielsweise eine Waschmaschine, ein Wäschetrockner, eine Geschirrspülmaschine, ein Gargerät, eine Dunstabzugshaube, ein Kältegerät, eine Kühl-Gefrier-Kombination oder ein Klimagerät. Das kann aber auch ein Haushaltskleingerät sein, wie beispielsweise ein Kaffeevollautomat oder eine Küchenmaschine.

Prinzipiell kann der abzuziehende Amplitudenanteil ein über der Zeit konstanter Amplitudenanteil sein - er kann einmal für die gesamte Lebensdauer des Haushaltsgerätes eingestellt werden. Zum Beispiel kann der Amplitudenanteil zumindest 50 %, insbesondere zumindest 70 % des statischen Amplitudenanteils betragen, d. h. zumindest 50 % der Amplitude des Ausgangssignals, welche sich ohne eine Betätigung und ohne eine Annäherung einstellt. Da sich jedoch auch der statische Amplitudenanteil aufgrund sich verändernder Umgebungsbedingungen verändern kann, erweist sich als besonders vorteilhaft, wenn die Steuereinrichtung den abzuziehenden Amplitudenanteil dynamisch einstellen kann, nämlich insbesondere in Abhängigkeit von einer Amplitude des Subtraktionssignals. Die Steuereinrichtung empfängt nämlich das Subtraktionssignal und kann somit seine Amplitude messen und gegebenenfalls den abzuziehenden Amplitudenanteil verringern oder erhöhen. Auf diesem Wege gelingt es, den abzuziehenden Amplitudenanteil an die jeweils augenblicklich herrschenden Umgebungsbedingungen der Bedieneinrichtung und somit auf den jeweils momentanen statischen Amplitudenanteil des Ausgangssignals anzupassen.

Die Amplitude des Ausgangssignals der Aufbereitungsschaltung und somit des Subtraktionssignals ist nicht nur davon abhängig, ob eine Bedienperson den kapazitiven Sensor betätigt oder nicht. Wie bereits ausgeführt, beinhaltet diese Amplitude den - wenn auch bereits verringerten - statischen Amplitudenanteil, welcher durch eine Vielzahl von Einflussgrößen beeinflusst wird. Die Amplitude des Subtraktionssignals wird z. B. durch die Temperatur und die Feuchtigkeit der Umgebung sowie andere umgebungsbedingte Störgrößen beeinflusst. Um all diese Beeinflussungen der Amplitude des Subtraktionssignals zu kompensieren, kann die Steuereinrichtung die Amplitude des Subtraktionssignals auf einen vorgebbaren Sollwert - z. B. 2 Volt - einstellen, nämlich durch dynamische Einstellung des abzuziehenden Amplitudenanteils. Also kann die Amplitude des Subtraktionssignals auf einen konstanten Sollwert quasi geregelt werden. Diese Amplitude ist dann unabhängig von den Umgebungsbedingungen. Unabhängig von den Umgebungsbedingungen kann somit stets eine zuverlässige Auswertung des Subtraktionssignals gewährleistet werden. Die Steuereinrichtung kann nämlich feststellen, ob sich die momentane Amplitude des Subtraktionssignals aufgrund einer Betätigung und/oder einer Annäherung an den kapazitiven Sensor verändert, bevor die Steuereinrichtung die Amplitude des Subtraktionssignals wieder auf den Sollwert einstellt. Dies kann beispielsweise so aussehen, dass nach Einschalten des Haushaltsgerätes die Steuereinrichtung einmal die Amplitude des Subtraktionssignals durch entsprechende Einstellung des abzuziehenden Amplitudenanteils auf den Sollwert einstellt. Dann kann die Steuereinrichtung nach einer solchen Kalibrierung des Subtraktionssignals dieses Signal im Hinblick auf eine Betätigung und/oder eine Annäherung überwachen. Wird der Sensor betätigt, so erkennt die Steuereinrichtung diese Betätigung anhand der Amplitude des Subtraktionssignals; die Steuereinrichtung kann nach dieser Betätigung die Amplitude des Subtraktionssignals wieder auf den Sollwert einstellen.

Bevorzugt wird der abzuziehende Amplitudenanteil derart eingestellt, dass er zumindest 50 %, insbesondere zumindest 70 %, einer Amplitude des Ausgangssignals beträgt, die sich ohne die Betätigung und/oder ohne die Annäherung einstellt. Somit wird erreicht, dass zumindest 50 %, insbesondere zumindest 70 %, des statischen Amplitudenanteils von der Amplitude des Ausgangssignals der Aufbereitungsschaltung abgezogen wird, so dass ein verbessertes Verhältnis zwischen dem dynamischen Amplitudenanteil und dem statischen Amplitudenanteil des Ausgangssignals gegeben ist. Bei dieser Ausführungsform kann die Steuereinrichtung nach jedem Einschalten des Haushaltsgerätes zunächst die Amplitude des Ausgangssignals der Aufbereitungsschaltung - ohne eine Betätigung des Sensors - messen und dann den abzuziehenden Amplitudenanteil so einstellen, dass zumindest 50 %, insbesondere 70 %, von der Amplitude des Ausgangssignals, also zumindest 50 % von dem statischen Amplitudenanteil, abgezogen wird. Somit ist die Empfindlichkeit der Bedieneinrichtung entsprechend hoch.

Wird der Amplitudenanteil vom Ausgangssignal abgezogen, so ist die Amplitude des Subtraktionssignals relativ gering. Das Subtraktionssignal kann durch die Steuereinrichtung besser ausgewertet werden, wenn ein Verstärker eingesetzt wird, durch welchen das Subtraktionssignal verstärkt wird.

Die Aufbereitungsschaltung kann einen Transistor, insbesondere einen PNP-Bipolartransistor, umfassen. Der Kollektor des PNP-Bipolartransistors kann mit einem Ausgang der Aufbereitungsschaltung gekoppelt sein, an welchem das Ausgangssignal anliegt. Der Steueranschluss und der Emitter des PNP-Bipolartransistors können mit dem kapazitiven Sensor gekoppelt sein. Der Emitter kann mit einem Eingang der Aufbereitungsschaltung gekoppelt sein, an welchem das Eingangssignal anliegt. Mit dem Kollektor des PNP-Bipolartransistors kann auch ein Ausgangskondensator gekoppelt sein; dieser Ausgangskondensator kann zwischen dem Kollektor und einem Bezugspotential (Masse) geschaltet sein. Durch eine solche Ausgestaltung der Aufbereitungsschaltung kann erreicht werden, dass diese Schaltung eine Abfolge von Spannungsimpulsen als Ausgangssignal ausgeben kann, deren Höhe von der Kapazität des kapazitiven Sensors abhängt. Dadurch, dass kein Gleichspannungssignal ausgegeben wird, ist auch der Energieverbrauch der Aufbereitungsschaltung minimal.

Wie bereits ausgeführt, kann das Ausgangssignal und somit auch das Subtraktionssignal eine Mehrzahl von Spannungsimpulsen umfassen, deren Höhe durch die Steuereinrichtung ausgewertet wird. Diese Spannungsimpulse können aufgrund der Ausgestaltung der Aufbereitungsschaltung jeweils eine Spitze aufweisen, die gegebenenfalls durch die Steuereinrichtung nur mit großem Aufwand ausgewertet werden kann. Es erweist sich deshalb als besonders vorteilhaft, wenn ein Spitzendetektor (peak detector) eingesetzt wird, welcher eine maximale Amplitude (nämlich die Spitze) des Subtraktionssignals detektieren kann. Der Spitzendetektor kann dann einen Impuls mit einer konstanten Amplitude ausgeben, die gleich der maximalen Amplitude ist. Die Zeitdauer des ausgegebenen Impulses mit konstanter Amplitude wird bevorzugt durch die Steuereinrichtung selbst eingestellt.

Die Zeitdauer eines einzelnen Impulses kann beispielsweise in einem Wertebereich von 10 µs bis 50 µs liegen. Der zeitliche Abstand zwischen zwei nacheinander folgenden Impulsen kann z. B. in einem Wertebereich von 60 µs bis 100 µs liegen. Die Aufbereitungsschaltung kann mit jeweils wenigen Spannungsimpulsen in vorbestimmten Zeitabständen beaufschlagt werden, nämlich z. B. in Zeitabständen von 100 ms. Werden z. B. jeweils nur drei Spannungsimpulse innerhalb einer Zeit von 100 ms an die Aufbereitungsschaltung abgegeben, so ist die Leistungsaufnahme entsprechend sehr gering. Zum Zwecke der Beaufschlagung der Aufbereitungsschaltung mit Spannungsimpulsen kann die Steuereinrichtung mit einer Pulserzeugungseinheit bzw. einem Pulsgeber gekoppelt sein, welcher die Spannungsimpulse erzeugen kann. Eine solche Pulserzeugungseinheit kann aber auch ein Bestandteil der Steuereinrichtung sein, nämlich insbesondere eines Mikrocontrollers.

Die Auswertung des Subtraktionssignals kann z. B. so aussehen, dass die Steuereinrichtung die Amplitude des Subtraktionssignals mit einem Referenzwert vergleicht und abhängig von diesem Vergleich erkennt, ob eine Bedienperson den kapazitiven Sensor betätigt und/oder sich dem Sensor annähert oder nicht. Die Steuereinrichtung kann eine Betätigung oder Eine Annäherung beispielsweise dann bestätigen, wenn die Amplitude des Subtraktionssignals in einen vorgegebenen Referenzwertebereich liegt.

Ein erfindungsgemäßes Haushaltsgerät umfasst eine erfindungsgemäße kapazitive Bedieneinrichtung oder eine bevorzugte Ausgestaltung der Bedieneinrichtung.

Erfindungsgemäß wird darüber hinaus ein Verfahren zum Betreiben einer kapazitiven Bedieneinrichtung in einem Haushaltsgerät bereitgestellt. Die Bedieneinrichtung weist einen kapazitiven Sensor mit einer elektrischen Kapazität auf, die aufgrund einer Betätigung des Sensors durch eine Bedienperson und/oder einer Annäherung der Bedienperson an den Sensor verändert wird. Eine mit dem Sensor gekoppelte Aufbereitungsschaltung empfängt ein Eingangssignal und gibt ein von der Kapazität des Sensors abhängiges Ausgangssignal aufgrund des Eingangssignals aus. Eine mit der Aufbereitungsschaltung gekoppelte Steuereinrichtung stellt das Eingangssignal für die Aufbereitungsschaltung bereit und erkennt die Betätigung des Sensors und/oder die Annäherung an den Sensor abhängig von dem Ausgangssignal der Aufbereitungsschaltung. Es wird ein Amplitudenanteil von einer Amplitude des Ausgangssignals der Aufbereitungsschaltung abgezogen, und ein Subtraktionssignal wird als Ergebnis der Subtraktion erzeugt. Die Steuereinrichtung erkennt die Betätigung des Sensors und/oder die Annäherung an den Sensor anhand des Subtraktionssignals.

Die mit Bezug auf die erfindungsgemäße Bedieneinrichtung vorgestellten bevorzugten Ausführungsformen und deren Vorteile gelten entsprechend für das erfindungsgemäße Haushaltsgerät sowie das erfindungsgemäße Verfahren.

Weitere Merkmale der Erfindung ergeben sich aus den Ansprüchen, den Figuren und der Figurenbeschreibung. Alle vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder aber in Alleinstellung verwendbar.

Die Erfindung wird nun anhand einzelner bevorzugter Ausführungsbeispiele näher erläutert, wie auch unter Bezugnahme auf die beigefügten Zeichnungen.

Es zeigen:
- Fig. 1: in schematischer Darstellung ein Blockschaltbild einer kapazitiven Bedieneinrichtung eines Haushaltsgerätes gemäß einer Ausführungsform der Erfindung;
- Fig. 2: in schematischer Darstellung eine Aufbereitungsschaltung der Bedieneinrichtung gemäß Fig. 1;
- Fig. 3: in schematischer Darstellung ein Spitzendetektor der Bedieneinrichtung gemäß Fig. 1; und
- Fig. 4 bis 8: zeitliche Verläufe von Signalen der Bedieneinrichtung gemäß Fig. 1.

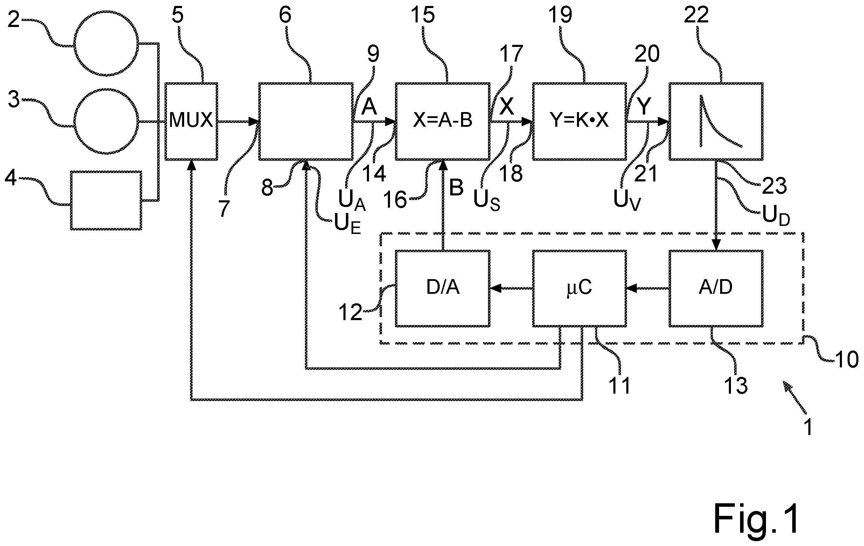

Eine kapazitive Bedieneinrichtung 1, wie sie in Fig. 1 in schematischer Darstellung gezeigt ist, befindet sich in einem Haushaltsgerät, nämlich beispielsweise in einer Waschmaschine. Die kapazitive Bedieneinrichtung 1 dient zum Bedienen des Haushaltsgerätes. Die Bedieneinrichtung 1 kann zumindest einen der folgenden kapazitiven Sensoren umfassen: einen kapazitiven Berührungssensor 2 und/oder einen kapazitiven Annäherungssensor 3 und/oder einen kapazitiven Sensor 4 mit einer zweidimensionalen Sensorfläche. Werden mehr als ein Sensor oder wird der Sensor 4 mit der zweidimensionalen Sensorfläche eingesetzt, so umfasst die Bedieneinrichtung 1 einen Multiplexer 5, der eingangsseitig mit den Sensoren 2, 3, 4 elektrisch gekoppelt ist. Ausgangsseitig ist der Multiplexer 5 mit einer Aufbereitungsschaltung 6 gekoppelt, die insgesamt zwei Eingänge 7, 8 sowie einen Ausgang 9 aufweist. Der Eingang 7 ist mit einem Ausgang des Multiplexer 5 gekoppelt, während der Eingang 8 mit einem Ausgang einer Steuereinrichtung 10 gekoppelt ist. Die Steuereinrichtung 10 dient zum Ansteuern der Bedieneinrichtung 1 und umfasst einen Mikrocontroller 11, wie auch einen Digital-Analog-Wandler 12 und einen Analog-Digital-Wandler 13.

Wird lediglich ein einziger Berührungssensor 2 oder ein einziger Annäherungssensor 3 eingesetzt, so kann auf den Multiplexer 5 verzichtet werden. Dann ist der einzige Sensor 2 oder 3 direkt mit der Aufbereitungsschaltung 6 verbunden.

Der Ausgang 9 der Aufbereitungsschaltung 6 ist mit Subtraktionsmitteln 15 gekoppelt, nämlich mit einem Eingang 14 der Subtraktionsmittel 15. Ein zweiter Eingang 16 der Subtraktionsmittel 15 ist mit einem Ausgang des Digital-Analog-Wandlers 12 gekoppelt. Ein Ausgang 17 der Subtraktionsmittel 15 ist mit einem Eingang 18 eines Verstärkers 19 gekoppelt, während ein Ausgang 20 des Verstärkers 19 mit einem Eingang 21 eines Spitzendetektors 22 verbunden ist. Ein Ausgang 23 der Spitzendetektors 22 ist mit einem Eingang des Analog-Digital-Wandlers 13 verbunden.

Der Digital-Analog-Wandler 12 und/oder der Analog-Digital-Wandler 13 kann/können auch in den Mikrocontroller 11 integriert sein.

Die Subtraktionsmittel 15 und der Verstärker 19 können jeweils durch einen integrierten Schaltkreis (Chip) gebildet sein.

Der Mikrokontroller 11 steuert auch den Multiplexer 5 an, nämlich unter Ausgabe entsprechender Steuersignale an einen Steuereingang des Multiplexers 5.

Der Berührungssensor 2 hat eine elektrische Kapazität, die aufgrund einer Betätigung des Sensors 2 durch eine Bedienperson verändert wird. Entsprechend weist der Annäherungssensor 3 eine elektrische Kapazität auf, die sich aufgrund einer Annäherung der Bedienperson an den Sensor 3 verändert. Der Sensor 4 kann beispielsweise eine Vielzahl von Reihen, wie auch eine Vielzahl von Spalten beinhalten, die jeweils zueinander elektrisch entkoppelt sind. Der Multiplexer 5 dient dazu, die Sensoren 2, 3, 4 sowie die Spalten und die Reihen des Sensors 4 abwechselnd und zyklisch an den Eingang 7 der Aufbereitungsschaltung 6 zu koppeln.

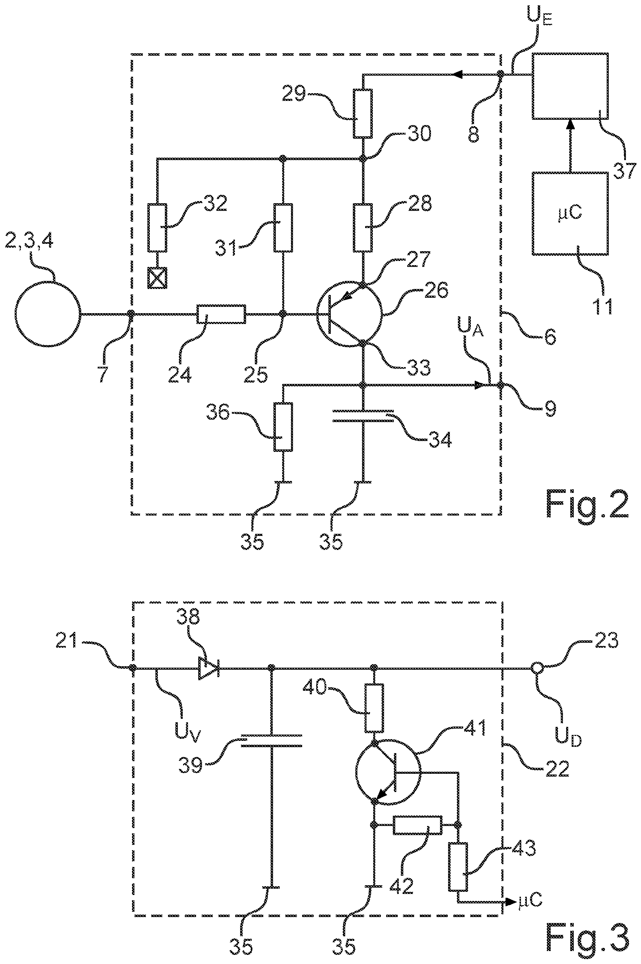

In Fig. 2 ist die Aufbereitungsschaltung 6 näher gezeigt. Der Eingang 7 ist über einen Ohmschen Widerstand 24 mit dem Steueranschluss 25 eines PNP-Bipolartransistors 26 gekoppelt. Der Emitter 27 des Bipolartransistors 26 ist über einen Ohmschen Widerstand 28, wie auch über einen weiteren Ohmschen Widerstand 29 mit dem Eingang 8 der Aufbereitungsschaltung 6 gekoppelt. Ein zwischen den Widerständen 28, 29 liegender Knoten 30 ist über einen Ohmschen Widerstand 31 mit dem Steueranschluss 25 sowie weiterhin mit einem Ohmschen Widerstand 32 verbunden, welcher auf der anderen Seite mit einer Sensorelektrode der Sensoren 2, 3, 4 gekoppelt sein kann. Der Kollektor 33 des Bipolartransistors 26 ist mit dem Ausgang 9 der Aufbereitungsschaltung 6 verbunden; des Weiteren ist der Kollektor 33 über einen Ausgangskondensator 34 mit einem Bezugspotential 35 gekoppelt. Parallel zum Ausgangskondensator 34 ist ein Ohmscher Widerstand 36 geschaltet. Der Mikrocontroller 11 - gegebenenfalls über einen Pulsgeber 37 - stellt am Eingang 8 der Aufbereitungsschaltung 6 ein Eingangssignal U_{E} bereit, welches ein Spannungssignal ist. Am Ausgang 9 wird hingegen ein Ausgangssignal U_{A} ausgegeben - ebenfalls ein Spannungssignal.

Fig. 3 zeigt in schematischer Darstellung den Spitzendetektor 22. Der Eingang 21 ist über eine Diode 38 - in Durchlassrichtung - mit dem Ausgang 23 gekoppelt. Die Kathode der Diode 38 ist über einen Kondensator 39 mit dem Bezugspotential 35 gekoppelt. Parallel zum Kondensator 39 ist eine Reihenschaltung aus einem Ohmschen Widerstand 40 sowie einem NPN-Bipolartransistor 41 geschaltet. Der Widerstand 40 ist mit dem Kollektor des Bipolartransistors 41 verbunden, während der Emitter mit dem Bezugspotential 35 verbunden ist. Der Emitter ist außerdem über einen Ohmschen Widerstand 42 mit dem Steueranschluss des Bipolartransistors 41 gekoppelt; der Steueranschluss ist auch über einen weiteren Ohmschen Widerstand 43 mit einem Steuerausgang des Mikrocontrollers 11 gekoppelt.

Nachfolgend wird die Funktionsweise der Bedieneinrichtung 1 gemäß Fig. 1 näher erläutert.

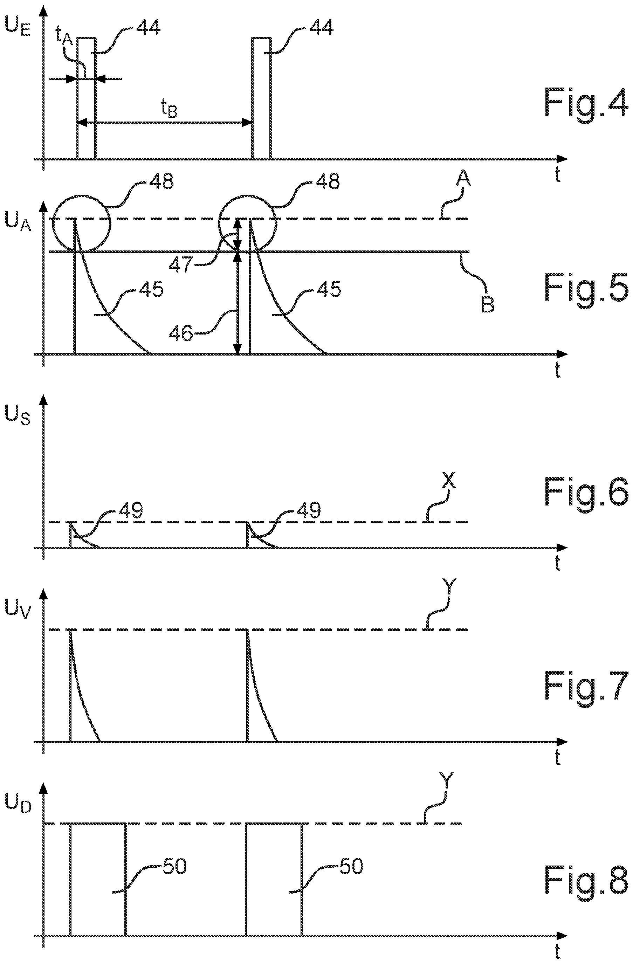

Die Steuereinrichtung 10 beaufschlagt die Aufbereitungsschaltung 6 mit dem Eingangssignal U_{E}. Dieses Eingangssignal U_{E} beinhaltet eine vorbestimmte Anzahl von Spannungsimpulsen 44, die jeweils in vorbestimmten Zeitabständen erzeugt wird. Ein beispielhafter Verlauf des Eingangssignals U_{E} über der Zeit t ist in Fig. 4 dargestellt. Eine Zeitdauer t_{A} eines Spannungsimpulses 44 liegt in einem Wertebereich von 10 µs bis 50 µs. Ein zeitlicher Abstand t_{B} zwischen zwei nacheinander folgenden Spannungsimpulsen 44 liegt in einem Wertebereich von 60 µs bis 100 µs.

Die Aufbereitungsschaltung 6 empfängt die Spannungsimpulse 44 und gibt das Ausgangssignal U_{A} aus, nämlich am Ausgang 9. Ein beispielhafter zeitlicher Verlauf des Ausgangssignals U_{A} ist in Fig. 5 dargestellt. Das Ausgangssignal U_{A} beinhaltet ebenfalls Spannungsimpulse 45, deren Amplitude A von der Kapazität des Sensors 2, 3, 4 abhängt. Die ausgegebenen Spannungsimpulse 45 beinhalten insgesamt zwei verschiedene Amplitudenanteile, nämlich einen statischen Amplitudenanteil 46 sowie einen dynamischen Amplitudenanteil 47. Der statische Amplitudenanteil 46 ist derjenige Anteil, der abhängig von einem statischen Anteil der Kapazität des Sensors 2, 3, 4 ist. Der statische Amplitudenanteil 46 hängt somit von Umgebungsbedingungen ab, wie insbesondere von der Umgebungstemperatur sowie der Feuchtigkeit. Der statische Amplitudenanteil 46 hängt jedoch auch von einer parasitären Kapazität der verwendeten Platine (PCB) ab. Für die Auswertung des Ausgangssignals U_{A} durch den Mikrocontroller 11 ist der statische Amplitudenanteil 46 im Prinzip irrelevant. Demgegenüber ist der dynamische Amplitudenanteil 47 alleine von derjenigen Kapazität des Sensors 2, 3, 4 abhängig, die auf eine Betätigung bzw. Annäherung zurückzuführen ist. Somit ist der dynamische Amplitudenanteil 47 relevant für die Auswertung durch den Mikrocontroller 11. Die relevanten Bereiche der Spannungsimpulse 45 sind in Fig. 5 schematisch dargestellt und mit 48 bezeichnet.

Um die Empfindlichkeit der Bedieneinrichtung 1 gegenüber dem Stand der Technik zu verbessern, wird von der Amplituden A der Spannungsimpulse 45 ein Amplitudenanteil B abgezogen, nämlich mithilfe der Subtraktionsmittel 15. Der abzuziehende Amplitudenanteil B wird durch die Steuereinrichtung 10 eingestellt. Zu diesem Zwecke wird der Digital-Analog-Wandler 12 durch den Mikrocontroller 11 entsprechend angesteuert.

Am Ausgang 17 der Subtraktionsmittel 15 liegt somit ein Subtraktionssignal U_{S} an, welches eine Amplitude X aufweist. Es gilt: X = A - B. Ein beispielhafter zeitlicher Verlauf des Subtraktionssignals U_{S} ist in Fig. 6 gezeigt. Dieses Subtraktionssignal U_{S} umfasst ebenfalls Spannungsimpulse 49, welche die Amplitude X haben.

Das Subtraktionssignal U_{S} wird dann durch den Verstärker 19 verstärkt. Der Verstärker 19 gibt ein verstärktes Subtraktionssignal U_{V}, dessen Amplitude Y um einen Faktor K größer als die Amplitude X des Subtraktionssignals U_{S} ist. Das verstärkte Subtraktionssignal U_{V} ist in Fig. 7 gezeigt. Es liegt am Eingang 21 des Spitzendetektors 22 an. Der Spitzendetektor 22 detektiert die maximale Amplitude Y der Spitzen des verstärkten Subtraktionssignals U_{V} und gibt ein Auswertungssignal U_{D} an die Steuereinrichtung 10 aus, nämlich über den Ausgang 23. Ein beispielhafter zeitlicher Verlauf des Auswertungssignals U_{D} ist in Fig. 8 gezeigt. Wie aus Fig. 8 hervorgeht, umfasst das Auswertungssignal U_{D} Spannungsimpulse 50, deren Amplitude gleich der Amplitude Y des verstärkten Signals U_{V} ist. Diese maximale Amplitude Y wird jedoch bei den Spannungsimpulsen 50 über eine vorbestimmte Zeitdauer konstant gehalten, die durch den Mikrokontroller 11 eingestellt werden kann, nämlich über den Bipolartransistor 41 (siehe Fig. 3).

In einer Ausführungsform wird der abzuziehende Amplitudenanteil B durch die Steuereinrichtung 10 so eingestellt, dass die Amplitude Y des Auswertungssignals U_{D} gleich einem vorgebbaren Sollwert ist. Der Mikrokontroller 11 kann nämlich die Amplitude Y des Auswertungssignals U_{D} messen und gegebenenfalls den abzuziehenden Amplitudenanteil B verändern. Insbesondere wird der abzuziehende Amplitudenanteil B so gewählt, dass zumindest 70 % des statischen Amplitudenanteils 46 des Ausgangssignals U_{A} abgezogen wird. Dieser statische Amplitudenanteil 46 kann auch vollständig abgezogen werden. Der statische Amplitudenanteil 46 entspricht nämlich derjenigen Amplitude des Ausgangssignals U_{A}, die sich ohne eine Betätigung und ohne eine Annäherung einstellt.

Also empfängt die Steuereinrichtung 10 das Auswertungssignal U_{D}, welches die in Fig. 8 dargestellten Spannungsimpulse 50 umfasst. Anhand der Amplitude Y der Spannungsimpulse 50 kann der Mikrocontroller 11 feststellen, ob eine Betätigung und/oder eine Annäherung einer Bedienperson vorliegt oder nicht. Zum Beispiel kann der Mikrocontroller 11 die Amplitude Y des Auswertungssignals U_{D} mit einem Referenzsignal vergleichen. Beispielsweise kann der Mikrocontroller 11 überprüfen, ob die Amplitude Y in einem vorgegebenen Referenzwertebereich liegt oder nicht. Liegt die Amplitude Y im Referenzwertebereich, so kann dies durch den Mikrocontroller 11 dahingehend ausgewertet werden, dass die Betätigung und/oder die Annäherung vorliegt.

Insgesamt wird eine Bedieneinrichtung 1 bereitgestellt, die gegenüber den bekannten kapazitiven Bedieneinrichtungen eine verbesserte Empfindlichkeit aufweist. Durch das Abziehen des vorgebbaren Amplitudenanteils B von der Amplitude A des Ausgangssignals U_{A} kann ein besseres Verhältnis des dynamischen Amplitudenanteils 47 zum statischen Amplitudenanteil 46 erreicht werden.

### Bezugszeichenliste

- 1: Bedieneinrichtung
- 2: Berührungssensor
- 3: Annäherungssensor
- 4: zweidimensionaler Sensor
- 5: Multiplexer
- 6: Aufbereitungsschaltung
- 7: Eingang
- 8: Eingang
- 9: Ausgang
- 10: Steuereinrichtung
- 11: Mikrocontroller
- 12: Digital-Analog-Wandler
- 13: Analog-Digital-Wandler
- 14: Eingang
- 15: Subtraktionsmittel
- 16: Eingang
- 17: Ausgang
- 18: Eingang
- 19: Verstärker
- 20: Ausgang
- 21: Eingang
- 22: Spitzendetektor
- 23: Ausgang
- 24: Widerstand
- 25: Steueranschluss
- 26: PNP-Bipolartransistor
- 27: Emitter
- 28: Widerstand
- 29: Widerstand
- 30: Knoten
- 31: Widerstand
- 32: Widerstand
- 33: Kollektor
- 34: Ausgangskondensator
- 35: Bezugspotential
- 36: Widerstand
- 37: Pulsgeber
- 38: Diode
- 39: Kondensator
- 40: Widerstand
- 41: Bipolartransistor
- 42: Widerstand
- 43: Widerstand
- 44: Spannungsimpulse
- 45: Spannungsimpulse
- 46: statischer Amplitudenanteil
- 47: dynamischer Amplitudenanteil
- 48: relevante Bereiche
- 49: Spannungsimpulse
- 50: Spannungsimpulse

- A: Amplitude
- B: abzuziehender Amplitudenanteil
- X: Amplitude
- Y: Amplitude
- K: Faktor
- t: Zeit
- t_{A}: Zeitdauer
- t_{B}: zeitlicher Abstand
- U_{A}: Ausgangssignal
- U_{D}: Auswertungssignal
- U_{E}: Eingangssignal
- U_{S}: Subtraktionssignal
- U_{V}: verstärkter Subtraktionssignal

## Patentansprüche

1. Kapazitive Bedieneinrichtung (1) für ein Haushaltsgerät, mit:
- einem kapazitiven Sensor (2, 3, 4) mit einer elektrischen Kapazität, die aufgrund einer Betätigung des Sensors (2, 3, 4) durch eine Bedienperson und/oder einer Annäherung der Bedienperson an den Sensor (2, 3, 4) veränderbar ist,
- einer mit dem Sensor (2, 3, 4) gekoppelten Aufbereitungsschaltung (6) zum Empfangen eines Eingangssignals (U_{E}) und zum Ausgeben eines von der Kapazität des Sensors (2, 3, 4) abhängigen Ausgangssignals (U_{A}) aufgrund des Eingangssignals (U_{E}), und
- einer mit der Aufbereitungsschaltung (6) gekoppelten Steuereinrichtung (10) zum Bereitstellen des Eingangssignals (U_{E}) für die Aufbereitungsschaltung (6) und zum Erkennen der Betätigung des Sensors (2, 3, 4) und/oder der Annäherung an den Sensor (2, 3, 4) in Abhängigkeit von dem Ausgangssignal (U_{A}) der Aufbereitungsschaltung (6),
wobei Subtraktionsmittel (15) vorgesehen sind, die zum Abziehen eines Amplitudenanteils (B) von einer Amplitude (A) des Ausgangssignals (U_{A}) der Aufbereitungsschaltung (6) und zum Ausgeben eines Subtraktionssignals (U_{S}) als Ergebnis der Subtraktion ausgebildet sind, wobei die Steuereinrichtung (10) dazu ausgelegt ist, anhand des Subtraktionssignals (U_{S}) die Betätigung des Sensors (2, 3, 4) und/oder die Annäherung an den Sensor (2, 3, 4) zu erkennen,
**dadurch gekennzeichnet, dass**
die Aufbereitungsschaltung (6) dazu ausgebildet ist, ein Eingangssignal (U_{E}) mit einer Mehrzahl von Impulsen (44) zu empfangen und aufgrund des Eingangssignals (U_{E}) ein Ausgangssignal (U_{A}) mit einer entsprechenden Mehrzahl von Impulsen (45) auszugeben, und
die Steuereinrichtung (10) dazu ausgelegt ist, für die Aufbereitungsschaltung (6) ein solches Eingangssignal (U_{E}) bereitzustellen, welches in vorbestimmten Zeitabständen jeweils eine vorbestimmte Anzahl von Impulsen (44) umfasst.

2. Kapazitive Bedieneinrichtung (1) nach Anspruch 1, **dadurch gekennzeichnet, dass** die Steuereinrichtung (10) dazu ausgelegt ist, den abzuziehenden Amplitudenanteil (B) in Abhängigkeit von einer Amplitude (X) des Subtraktionssignals (U_{S}) einzustellen.

3. Kapazitive Bedieneinrichtung (1) nach Anspruch 2, **dadurch gekennzeichnet, dass** die Steuereinrichtung (10) dazu ausgelegt ist, durch Einstellung des abzuziehenden Amplitudenanteils (B) die Amplitude (X) des Subtraktionssignals (U_{S}) auf einen vorgebbaren Sollwert einzustellen.

4. Kapazitive Bedieneinrichtung (1) nach einem der vorhergehenden Ansprüche,
**dadurch gekennzeichnet, dass** die Steuereinrichtung (10) dazu ausgelegt ist, den abzuziehenden Amplitudenanteil (B) derart einzustellen, dass der Amplitudenanteil (B) zumindest 50 %, insbesondere zumindest 70 %, einer Amplitude (A) des Ausgangssignals (U_{A}) beträgt, die sich ohne die Betätigung und/oder ohne die Annäherung einstellt.

5. Kapazitive Bedieneinrichtung (1) nach einem der vorhergehenden Ansprüche, **gekennzeichnet durch** einen Verstärker (19) zum Verstärken des Subtraktionssignals (U_{S}).

6. Kapazitive Bedieneinrichtung (1) nach einem der vorhergehenden Ansprüche, **gekennzeichnet durch** einen Spitzendetektor (22), der dazu ausgelegt ist, eine maximale Amplitude (Y) des Subtraktionssignals (U_{S}) zu detektieren und einen Impuls (50) mit einer konstanten Amplitude (Y) auszugeben, die gleich der maximalen Amplitude (Y) ist.

7. Kapazitive Bedieneinrichtung (1) nach einem der vorhergehenden Ansprüche,
**dadurch gekennzeichnet, dass** die Aufbereitungsschaltung (6) einen Transistor (26), insbesondere einen PNP-Bipolartransistor (26), umfasst, dessen Kollektor (33) mit einem Ausgang (9) der Aufbereitungsschaltung (6) gekoppelt ist, an welchem das Ausgangssignal (U_{A}) anliegt, und dessen Steueranschluss (25) und Emitter (27) mit dem kapazitiven Sensor (2, 3, 4) gekoppelt sind, wobei der Emitter (27) mit einem Eingang (7) der Aufbereitungsschaltung (6) gekoppelt ist, an welchem das Eingangssignal (U_{E}) anliegt.

8. Kapazitive Bedieneinrichtung (1) nach einem der vorhergehenden Ansprüche,
**dadurch gekennzeichnet, dass** die Zeitdauer (t_{A}) eines einzelnen Impulses (44) in einem Wertebereich von 10 µs bis 50 µs liegt und/oder der zeitliche Abstand (t_{B}) zwischen zwei nacheinander folgenden Impulsen (44) in einem Wertebereich von 60 µs bis 100 µs liegt.

9. Kapazitive Bedieneinrichtung (1) nach einem der vorhergehenden Ansprüche,
**dadurch gekennzeichnet, dass** die Steuereinrichtung (10) dazu ausgelegt ist, die Amplitude des Subtraktionssignals (U_{S}) mit einem Referenzwert zu vergleichen und abhängig von dem Vergleich die Betätigung und/oder die Annäherung zu erkennen.

10. Haushaltsgerät mit einer kapazitiven Bedieneinrichtung (1) nach einem der vorhergehenden Ansprüche.

11. Verfahren zum Betreiben einer kapazitiven Bedieneinrichtung (1) in einem Haushaltsgerät, wobei:
- die Bedieneinrichtung (1) einen kapazitiven Sensor (2, 3, 4) mit einer elektrischen Kapazität aufweist, die aufgrund einer Betätigung des Sensors (2, 3, 4) durch eine Bedienperson und/oder einer Annäherung der Bedienperson an den Sensor (2, 3, 4) verändert wird,
- eine mit dem Sensor (2, 3, 4) gekoppelte Aufbereitungsschaltung (6) ein Eingangssignal (U_{E}) empfängt und ein von der Kapazität des Sensors (2, 3, 4) abhängiges Ausgangssignal (U_{A}) aufgrund des Eingangssignals (U_{E}) ausgibt, und
- eine mit der Aufbereitungsschaltung (6) gekoppelte Steuereinrichtung (10) das Eingangssignal (U_{E}) für die Aufbereitungsschaltung (6) bereitstellt und die Betätigung des Sensors (2, 3, 4) und/oder die Annäherung an den Sensor (2, 3, 4) in Abhängigkeit von dem Ausgangssignal (U_{A}) der Aufbereitungsschaltung (6) erkennt,
wobei ein Amplitudenanteil (B) von einer Amplitude (A) des Ausgangssignals (U_{A}) der Aufbereitungsschaltung (6) abgezogen wird und ein Subtraktionssignal (U_{S}) als Ergebnis der Subtraktion erzeugt wird, wobei die Steuereinrichtung (10) die Betätigung des Sensors (2, 3, 4) und/oder die Annäherung an den Sensor (2, 3, 4) anhand des Subtraktionssignals (U_{S}) erkennt
**dadurch gekennzeichnet, dass**
die Aufbereitungsschaltung (6) ein Eingangssignal (U_{E}) mit einer Mehrzahl von Impulsen (44) empfängt und aufgrund des Eingangssignals (U_{E}) ein Ausgangssignal (U_{A}) mit einer entsprechenden Mehrzahl von Impulsen (45) ausgibt, und
die Steuereinrichtung (10) für die Aufbereitungsschaltung (6) ein solches Eingangssignal (U_{E}) bereitstellt, welches in vorbestimmten Zeitabständen jeweils eine vorbestimmte Anzahl von Impulsen (44) umfasst.

## Claims

1. Capacitative operating device (1) for a household appliance having:
- a capacitative sensor (2, 3, 4) with an electric capacitance, which can be changed as a result of an actuation of the sensor (2, 3, 4) by an operating person and/or the operating person approaching the sensor (2, 3, 4),
- a processing circuit (6) coupled to the sensor (2, 3, 4) for receiving an input signal (*U_{E}*) and for outputting an output signal (*U_{A}*) dependent on the capacitance of the sensor (2, 3, 4) as a result of the input signal (*U_{E}*), and
- a control device (10) coupled to the processing circuit (6) for providing the input signal (*U_{E}*) for the processing circuit (6) and for identifying the actuation of the sensor (2, 3, 4) and/or the sensor (2, 3, 4) being approached, as a function of the output signal (*U_{A}*) of the processing circuit (6),
wherein subtraction means (15) are provided, which are embodied to subtract an amplitude portion (B) from an amplitude (A) of the output signal (*U_{A}*) of the processing circuit (6) and to output a subtraction signal (*U_{S}*) as a result of the subtraction, wherein the control device (10) is designed to identify the actuation of the sensor (2, 3, 4) and/or the sensor (2, 3, 4) being approached on the basis of the subtraction signal (*U_{S}*),
**characterised in that**
the processing circuit (6) is embodied to receive an input signal (*U_{E}*) with a plurality of pulses (44) and on account of the input signal (*U_{E}*) to output an output signal (*U_{A}*) with a corresponding plurality of pulses (45), and
the control device (10) is designed to provide such an input signal (*U_{E}*) for the processing circuit (6), which comprises a predetermined number of pulses (44) at predetermined time intervals.

2. Capacitative operating device (1) according to claim 1, **characterised in that** the control device (10) is designed to set the amplitude portion (B) to be subtracted as a function of an amplitude (X) of the subtraction signal (*U_{S}*).

3. Capacitative operating device (1) according to claim 2, **characterised in that** the control device (10) is designed to set the amplitude (X) of the subtraction signal (*U_{S}*) to a predeterminable setpoint value by setting the amplitude portion (B) to be subtracted.

4. Capacitative operating device (1) according to one of the preceding claims, **characterised in that** the control device (10) is designed to set the amplitude portion (B) to be subtracted such that the amplitude portion (B) amounts to at least 50%, in particular at least 70%, of an amplitude (A) of the output signal (*U_{A}*), which is set without actuation and/or without being approached.

5. Capacitative operating device (1) according to one of the preceding claims, **characterised by** an amplifier (19) for amplifying the subtraction signal (*U_{S}*).

6. Capacitative operating device (1) according to one of the preceding claims, **characterised by** a peak detector (22), which is designed to detect a maximum amplitude (Y) of the subtraction signal (*U_{S}*) and to output a pulse (50) with a constant amplitude (Y) which is equal to the maximum amplitude (Y).

7. Capacitative operating device (1) according to one of the preceding claims, **characterised in that** the processing circuit (6) comprises a transistor (26), in particular a PNP bipolar transistor (26), the collector (33) of which is coupled to an input (9) of the processing circuit (6), at which the output signal (*U_{A}*) is present, and the control terminal (25) and emitter (27) of which are coupled to the capacitative sensor (2, 3, 4), wherein the emitter (27) is coupled to an input (7) of the processing circuit (6), at which the input signal (*U_{E}*) is present.

8. Capacitative operating device (1) according to one of the preceding claims, **characterised in that** the duration (*t_{A}*) of an individual pulse (44) lies in a value range of 10 µs to 50 µs and/or the time interval (*t_{B}*) lies between two consecutive pulses (44) in a value range of 60 µs to 100 µs.

9. Capacitative operating device (1) according to one of the preceding claims, **characterised in that** the control device (10) is designed to compare the amplitude of the subtraction signal (*U_{S}*) with a reference value and to identify the actuation and/or approach as a function of the comparison.

10. Household appliance with a capacitative operating device (1) according to one of the preceding claims.

11. Method for operating a capacitative operating device (1) in a household appliance, wherein:
- the operating device (1) has a capacitative sensor (2, 3, 4) with an electric capacitance, which is changed as a result of an actuation of the sensor (2, 3, 4) by an operating person and/or the operating person approaching the sensor (2, 3, 4),
- a processing circuit (6) coupled to the sensor (2, 3, 4) receives an input signal (*U_{E}*) and an output signal (*U_{A}*) dependent on the capacitance of the sensor (2, 3, 4) as a result of the input signal (*U_{E}*), and
- a control device (10) coupled to the processing circuit (6) provides the input signal (*U_{E}*) for the processing circuit (6) and identifies the actuation of the sensor (2, 3, 4) and/or sensor (2, 3, 4) being approached as a function of the output signal (*U_{A}*) of the processing circuit (6),
wherein an amplitude portion (B) is subtracted from an amplitude (A) of the output signal (*U_{A}*) of the processing circuit (6) and a subtraction signal (*U_{S}*) is produced as a result of the subtraction, wherein the control device (10) identifies the actuation of the sensor (2, 3, 4) and/or the sensor (2, 3, 4) being approached on the basis of the subtraction signal (*U_{S}*) **characterised in that**
the processing circuit (6) receives an input signal (*U_{E}*) with a plurality of pulses (44) and as a result of the input signal (*U_{E}*) outputs an output signal (*U_{A}*) with a corresponding plurality of pulses (45), and
the control device (10) for the processing circuit (6) provides such an input signal (*U_{E}*) which comprises a predetermined number of pulses (44) at predetermined time intervals in each case.

## Revendications

1. Dispositif de commande capacitif (1) pour un appareil électroménager, avec:
- un capteur capacitif (2, 3, 4) muni d'une capacité électrique, laquelle peut être modifiée par l'actionnement d'un capteur (2, 3, 4) par une personne autorisée et/ou par l'approche de la personne autorisée du capteur (2, 3, 4),
- un circuit de traitement (6) couplé du capteur (2, 3, 4) pour la réception d'un signal d'entrée (U_{E}) et pour l'émission d'un signal de sortie (U_{A}) dépendant de la capacité du capteur (2, 3, 4) sur base du signal d'entrée (U_{E}), et
- un dispositif de commande (10) couplé au circuit de traitement (6) pour procurer le signal d'entrée (U_{E}) pour le circuit de traitement (6) et pour la reconnaissance de l'actionnement du capteur (2, 3, 4) et/ou de l'approche du capteur (2, 3, 4) en fonction du signal de sortie (U_{A}) du circuit de traitement (6),
des moyens de soustraction (15) étant prévus, lesquels sont réalisés pour la soustraction d'une composante d'amplitude (B) de l'amplitude (A) d'un signal de sortie (U_{A}) du circuit de traitement (6) et pour l'émission d'un signal de soustraction (Uₛ) comme résultat de la soustraction, le dispositif de commande (10) étant réalisé pour reconnaître à l'aide du signal de soustraction (Uₛ) l'actionnement du capteur (2, 3, 4) et/ou l'approche du capteur (2, 3, 4), **caractérisé en ce que**
le circuit de traitement (6) est réalisé pour recevoir un signal d'entrée (U_{E}) avec une pluralité d'impulsions (44) et pour émettre, sur base du signal d'entrée (U_{E}) un signal de sortie (U_{A}) avec une pluralité correspondante d'impulsions (45), et
le dispositif de commande (10) est réalisé pour procurer, pour le circuit de traitement (6) un signal d'entrée (U_{E}) tel, qu'il comprend, à intervalles prédéterminés, un nombre prédéterminé d'impulsions (44).

2. Dispositif de commande capacitif (1) selon la revendication 1, **caractérisé en ce que** le dispositif de commande (10) est réalisé pour régler la composante d'amplitude (B) à soustraire en fonction de l'amplitude (X) du signal de soustraction (Uₛ).

3. Dispositif de commande capacitif (1) selon la revendication 2, **caractérisé en ce que** le dispositif de commande (10) est réalisé pour régler, par le réglage de la composante d'amplitude (B) à soustraire, l'amplitude (X) du signal de soustraction (Uₛ) sur une valeur théorique prédéfinissable.

4. Dispositif de commande capacitif (1) selon l'une des revendications précédentes, **caractérisé en ce que** le dispositif de commande (10) est réalisé pour régler la composante d'amplitude (B) à soustraire de manière que la composante d'amplitude (B) vaille au moins 50%, en particulier au moins 70%, d'une amplitude (A) du signal de sortie (U_{A}), qui se règle sans actionnement et/ou sans approche.

5. Dispositif de commande capacitif (1) selon l'une des revendications précédentes, **caractérisé par** un amplificateur (19) pour l'amplification du signal de soustraction (Uₛ).

6. Dispositif de commande capacitif (1) selon l'une des revendications précédentes, **caractérisé par** un détecteur de crête (22) réalisé pour détecter l'amplitude maximale (Y) du signal de soustraction (Uₛ) et pour émettre une impulsion (50) avec une amplitude (Y) constante, laquelle est égale à l'amplitude (Y) maximale.

7. Dispositif de commande capacitif (1) selon l'une des revendications précédentes, **caractérisé en ce que** le circuit de traitement (6) comprend un transistor (26), en particulier un transistor bipolaire PNP (26) dont le collecteur (33) est couplé à une sortie (9) du circuit de traitement (6), où se trouve le signal de sortie (U_{A}) et dont le raccord de commande (25) et l'émetteur (27) sont couplés du capteur capacitif (2, 3, 4), l'émetteur (27) étant couplé à une entrée (7) du circuit de traitement (6) où se trouve le signal d'entrée (U_{E}).

8. Dispositif de commande capacitif (1) selon l'une des revendications précédentes, **caractérisé en ce que** la durée (t_{A}) d'une seule impulsion (44) se situe dans une plage de valeurs comprise entre 10 µs et 50 µs et/ou la distance temporelle (t_{B}) entre deux impulsions successives (44) se situe dans une plage de valeurs allant de 60 µs à 100 µs.

9. Dispositif de commande capacitif (1) selon l'une des revendications précédentes, **caractérisé en ce que** le dispositif de commande (10) est réalisé pour comparer l'amplitude du signal de soustraction (U_{S}) avec une valeur de référence et pour reconnaître, en fonction de cette comparaison, l'actionnement et/ou l'approche.

10. Appareil électroménager avec dispositif de commande capacitif (1) selon l'une des revendications précédentes.

11. Procédé de fonctionnement d'un dispositif de commande capacitif (1) dans un appareil électroménager:
- le dispositif de commande (1) présentant un capteur capacitif (2, 3, 4) muni d'une capacité électrique, laquelle peut être modifiée par l'actionnement d'un capteur (2, 3, 4) par une personne autorisée et/ou l'approche de la personne autorisée du capteur (2, 3, 4),
- un circuit de traitement (6) couplé au capteur (2, 3, 4) recevant un signal d'entrée (U_{E}) et émettant un signal de sortie (U_{A}) dépendant de la capacité du capteur (2, 3, 4) sur base du signal d'entrée (U_{E}), et
- un dispositif de commande (10) couplé au circuit de traitement (6) procurant le signal d'entrée (U_{E}) pour le circuit de traitement (6) et reconnaissant l'actionnement du capteur (2, 3, 4) et/ou l'approche du capteur (2, 3, 4) en fonction du signal de sortie (U_{A}) du circuit de traitement (6),
une composante d'amplitude (B) d'une amplitude (A) du signal de sortie (U_{A}) étant soustraite du circuit de traitement (6) et un signal de soustraction (U_{S}) étant produit comme résultat de la soustraction, le dispositif de commande (10) reconnaissant l'actionnement du capteur (2, 3, 4) et/ou l'approche du capteur (2, 3, 4) à l'aide du signal de soustraction (U_{S}),
**caractérisé en ce que**
le circuit de traitement (6) reçoit un signal d'entrée (U_{E}) avec une pluralité d'impulsions (44) et émet, sur base du signal d'entrée (U_{E}), un signal de sortie (U_{A}) avec une pluralité correspondante d'impulsions (45), et
le dispositif de commande (10) procure, pour le circuit de traitement (6) un signal d'entrée (U_{E}) tel, qu'il comprend, à intervalles prédéterminés, chaque fois un nombre prédéterminé d'impulsions (44).
